# EUROPEAN PATENT APPLICATION

(11) **EP 2 666 746 A1**
(43) Date of publication of application: **27.11.2013**
(21) Application number: 12736403.2
(22) Date of filing: 06.01.2012
(51) Int. Cl.: B81C 99/00, C08F 2/10, C08F 26/00

(54) **METHOD OF PRODUCING FINELY STRUCTURED GEL**

(30) Priority: 21.01.2011 JP 2011011425
(71) Applicant: Terumo Kabushiki Kaisha, Tokyo 151-0072 (JP); The University of Tokyo, Bunkyo-Ku Tokyo 113-8654 (JP)
(72) Inventor: SHIBATA, Hideaki, Ashigarakami-gun Kanagawa 259-0151 (JP); TAKEUCHI, Shoji, Tokyo 113-8654 (JP); HEO, Yun-Jung, Meguro-ku, Tokyo 153-8505 (JP)
(74) Representative: TBK
(86) International application number: PCT/JP2012/050196
(87) International publication number: WO 2012/098942

(57) **Abstract**

An object of the present invention is to provide a method of producing a fine polymer gel, which can produce the gel in large quantities in a short period of time in a very simple manner without the need for large-scale facilities.

The present invention provides a method of producing a microstructured gel in a shape in accordance with a pattern, the method comprising the steps of: dropping a polymerizable monomer aqueous solution containing a polymerizable monomer component onto a portion of a surface of a substrate having a pattern comprising a fine groove in the surface;
moving by capillary action the polymerizable monomer aqueous solution along the groove constituting the pattern; and
subjecting the polymerizable monomer aqueous solution in the groove to polymerization.

## Description

### Technical Field

The present invention relates to a method of producing a microstructured gel.

### Background Art

Polymer gels as functional materials have been regarded as beneficial materials that have four roles: (1) flexible materials such as biological tissues; (2) materials in open systems that can exchange energy and substances with the outside world; (3) materials that have an intelligent function with the ability to sense information on the outside world, make a decision, and take action; or (4) materials that can control the development of the intelligent function on the spatial axis and the temporal axis, and attracting attention in various areas such as medical, chemistry, electronic industry, building industry, food industry, and agriculture.

Above all, in recent years, in the fields of micromachine and nanotechnology, attention has been focused on the forms and sizes polymer gels as functional materials, and an attempt has been made to make polymer gels finer by photolithography or X-ray lithography.

For example, G. Chen, Y. Imanishi and Y. Ito, Macromolecules, 31, 4379 1998 discloses a method of synthesizing a mesh-like microgel, in which a photoactive temperature-sensitive polymer obtained by introducing azidoaniline into a -COOH group of a NIPAAm/AAc copolymer is applied onto a glass substrate, dried, then covered with a photomask with a micropattern on the order of **µ**m created, irradiated with UV, and cleaned to remove the unreacted polymer.

In addition, for example, O. Tabata, H. Hirakawa, S. Aoki, R. Yoshida and E. Kokufuta Sensors and Actuators A, 95, 234 2002 discloses a method of preparing an "artificial cilium" with hundreds of minute projections arranged in an array on a surface, in which a microscopic three-dimensional mold is first created to synthesize a gel therein by three-dimensional microfabrication technology such as LIGA using synchrotron radiation.

Besides, Japanese Patent No. 4307794 discloses a method of preparing a finely structured silicone resin compact, in which after a mold with cavities of 2 **µ**m in width and 10 **µ**m in depth formed in a matrix in a plane is obtained from amorphous carbon as a substrate with the use of a focused ion beam processing apparatus, a step of injecting a silicone resin material dissolved in a solvent into the mold through an ink-jet nozzle and heating the material is repeated until the mold is filled with the material.

### Summary of Invention

The techniques in G. Chen, Y. Imanishi and Y. Ito, Macromolecules, 31, 4379 1998 and O. Tabata, H. Hirakawa, S. Aoki, R. Yoshida and E. Kokufuta, Sensors and Actuators A, 95, 234 2002 cited above are both important techniques that relate to polymer gel microfabrication. However, the technique disclosed in G.Chen, Y. Imanishi and Y. Ito, Macromolecules, 31, 4379 1998 has the problem of being remarkably troublesome and time-consuming, because there is a need to carry out the series of photolithography steps every time a mesh-like microgel is synthesized. In addition, there are problems of not only time consumption, but also remarkably large-scale facilities for production, because the invention described in Japanese patent No. 4307794 requires the FIB processing apparatus, whereas the method described in O. Tabata, H. Hirakawa, S. Aoki, R. Yoshida and E. Kokufuta, Sensors and Actuators A, 95, 234 2002 requires synchrotron radiation.

Therefore, an object of the present invention is to provide a method of producing a microstructured polymer gel, which can produce the gel in large quantities in a short period of time in a very simple manner without the need for large-scale facilities.

According to the production method in accordance with the present invention, the microstructured gel which has a desired pattern can be produced in a simple manner in large quantities in a short time.

Other objects, features and characteristics of the present invention will become more apparent by reference to preferred embodiments illustrated in the following description and the accompanying drawings.

### Brief Description of Drawings

FIG. 1A is a photograph of an example of a pattern composed of fine grooves formed in the surface of a substrate according to the present invention, and FIG. 1B is a schematic diagram of the pattern of FIG. 1A.
FIG. 2A is a photograph of an example of a pattern composed of fine grooves formed in the surface of a substrate according to the present invention, and FIG. 2B is a schematic diagram of the pattern of FIG. 2A.
FIG. 3 is a schematic diagram showing a step of moving a polymerizable monomer aqueous solution according to the present invention by capillary action along the grooves constituting the pattern of FIG. 1A, and the shape of a polymerized gel.
FIG. 4 is a schematic diagram showing a step of moving a polymerizable monomer aqueous solution according to the present invention by capillary action along the grooves constituting the pattern of FIG. 2A, and the shape of a polymerized gel.
FIG. 5 is an SEM image of a microstructured gel that is in dried state. The dried gel was obtained by polymerization of a polymerizable monomer aqueous solution in a substrate that has a pattern, then immersing in a solvent, and then taking from the substrate.FIG. 6 is a photograph of gel fibers obtained by a production method according to the present invention with the use of a substrate that has the pattern of FIG. 1A.
FIG. 7 is a photograph of gel mesh obtained by a production method according to the present invention with the use of a substrate that has the pattern of FIG. 1B.
FIG. 8 is a photograph showing, with time, the movement of a polymerizable monomer aqueous solution according to the present invention by capillary action along grooves constituting a pattern.
FIG. 9 is a schematic diagram illustrating an example of forming a pattern composed of fine grooves formed in the surface of a substrate according to the present invention. Description of Embodiments

An embodiment of the present invention will be described below in detail.

Furthermore, the present application is based on Japanese Patent Application No. 2011-011425 filed on January 21, 2011, the disclosure of which is entirely incorporated by reference.

A first aspect of the present invention is a method of producing a microstructured gel in a shape in accordance with a pattern, which includes the steps of: dropping a polymerizable monomer aqueous solution containing a polymerizable monomer component onto a portion of a surface of a substrate that has a pattern composed of fine grooves in the surface; moving by capillary action the polymerizable monomer aqueous solution along the grooves constituting the pattern; and subjecting the polymerizable monomer aqueous solution in the grooves to polymerization.

This method can produce a microstructured gel that has a desired pattern in a simple manner. The step of dropping a polymerizable monomer aqueous solution containing a polymerizable monomer component onto a portion of a surface of a substrate that has a pattern composed of fine grooves is referred to as a step (1); the step of moving by capillary action the polymerizable monomer aqueous solution along the grooves constituting the pattern is referred to as a step (2); and the step of subjecting the polymerizable monomer aqueous solution in the grooves to polymerization is referred to as a step (3), and each of the steps will be described below.

### (In regard to Step (1))

The step (1) in the method of producing a microstructured gel according to the present invention is a step of dropping a polymerizable monomer aqueous solution containing a polymerizable monomer component onto a portion of a substrate surface with a desired pattern created therein, with the use of the desired pattern continuously composed of fine grooves of linear concave sections. The desired pattern is created by forming the concave sections fine in terms of width and depth in the surface of the substrate in a linear and continuous manner.

It is to be noted that the surface of the substrate in which a pattern composed of fine grooves is formed will be hereinafter referred to as a substrate surface in this specification. The substrate surface refers to a concept excluding the bottom surfaces and side surfaces of the grooves.

The material of the substrate according to the present invention is not particularly limited, for which known materials can be used such as metals, glass, silicon, ceramics, and plastics, and above all, silicon is preferred because of workability. In addition, while the shape of the substrate according to the present invention is not particularly limited, plate-like substrates are preferred. Therefore, silicon wafers are preferred as the substrate according to the present invention. Furthermore, substrates with a surface subjected to a hydrophobic treatment or with a surface subjected to a thermal oxidation treatment may be used for the substrate according to the present invention.

In addition, while the size and thickness of the substrate according to the present invention are not particularly limited, which are selected appropriately depending on the size of the microstructured gel produced, for example, the size of the substrate according to the present invention may have an area on the order of 0.3 to 30 x 0.3 to 30 cm, and the thickness of the substrate according to the present invention may be 0.1 to 1 mm.

The pattern formed in the substrate according to the present invention is not particularly limited, for which a desired pattern can be created in the substrate, and preferably, at least one selected from the group consisting of lines, grids, polygons, wavy lines, spirals, stars, and honeycombs, and these patterns are not limited in the number thereof, because at least one or more of the patterns may be formed in the substrate. Furthermore, if necessary, the grooves constituting the pattern may be changed in width or depth in the middle of the lines.

The grooves of the pattern formed in the substrate according to the present invention are grooves extended continuously from the sites with the polymerizable monomer aqueous solution dropped thereon.

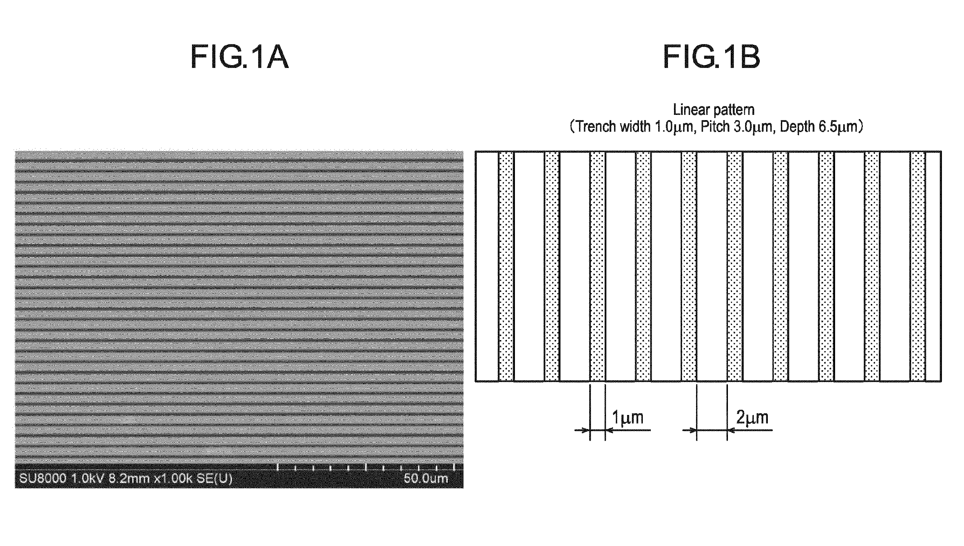

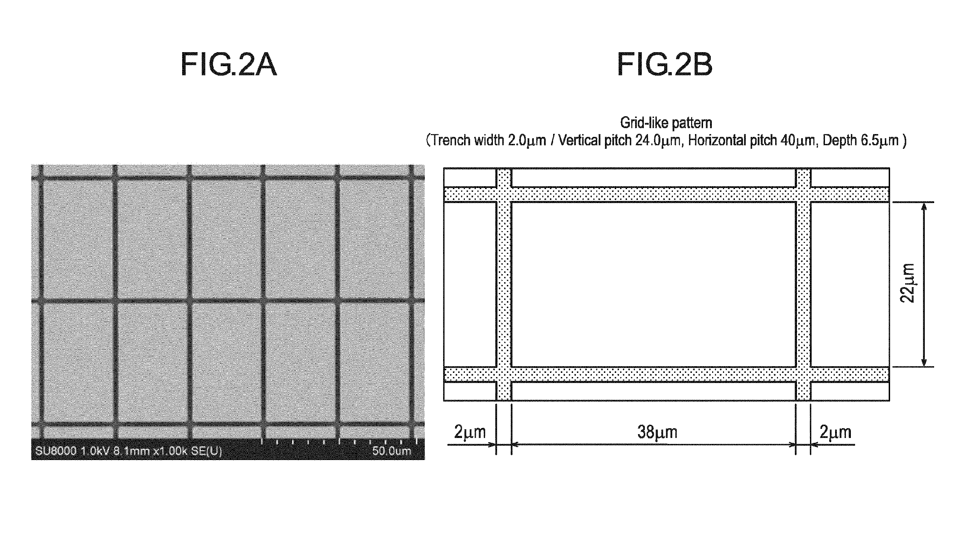

Further, FIGS. 1A and 1B show a photograph of a substrate with a fine linear groove pattern formed in the surface, whereas FIGS. 2A and 2B show a photograph of a substrate with a fine grid-like groove pattern formed in the surface.

The shape of the cross section orthogonal to the groove directional axis (cross-sectional groove), which constitutes the pattern formed in the substrate according to the present invention, is not particularly limited, and may be rectangular, triangle, fan-like, wedge-shaped, or U-shaped.

The grooves constituting the pattern formed in the substrate according to the present invention are preferably 80 nm to 1 mm in width, 100 nm to 1 cm in length, and 100 nm to 50 **µ**m in depth, and preferably 100 nm to 50 **µ**m in width, 100 **µ**m to 0.5 cm in length, and 1 **µ**m to 10 **µ**m in depth.

The groove width, length, and depth within the ranges mentioned above are preferred in terms of reduction in drying of the solution before polymerization, the strength of the prepared gel, and simpleness of removal from the pattern.

It is to be noted that, regardless of the shape of the groove cross section, the groove width refers to the maximum length of the gap between sidewalls, and the groove depth refers to the maximum depth in the concave section.

The method of producing the substrate with the pattern composed of fine grooves formed in the surface according to the present invention is not particularly limited, and examples of the method include known photolithography processes and known laser processing. In addition, the substrate with the pattern formed according to the present invention may be provided by purchasing a commercially available substrate or by producing.

For example, when a photolithography process is applied to the present invention, a substrate with a surface cleaned is, if necessary, subjected to a thermal oxidation treatment, and a predetermined resist is applied onto the surface of the substrate, subjected to pre-bake under predetermined conditions, then exposed to g-line or i-line with a desired patterned mask attached, and if necessary, subjected to development and rinsing, and to post-bake after PEB, and subjected to anisotropic or isotropic etching to remove the resist, an oxide film or the like, if necessary, thereby making it possible to provide the substrate with the pattern composed of fine groove formed in the surface according to the present invention.

It is to be noted that the photoresist material and etching conditions for use in the photolithography process are not particularly limited, and known materials and conditions can be used.

Alternatively, for example, when laser processing is applied to the present inventions, laser beams transmitted from a laser oscillator with the use of a reflecting mirror or the like are finely focused by a condenser lens to irradiate the substrate according to the present invention, thereby locally melting the substrate according to the present invention, and an assist gas is sprayed from a nozzle placed coaxially with the laser to blow out the melt, thereby making it possible to form a desired pattern of grooves.

It is to be noted that the type of the laser beams used can be appropriately selected depending on the material or the like of the substrate, and desired patterns can be formed under known conditions such as, for example, a YAG laser when the substrate is made of iron, or an FHG laser when the substrate is made of aluminum.

The method of producing the substrate with the pattern composed of fine grooves formed in the surface according to the present invention preferably uses the photolithography process. The photolithography process easily forms the shape of the groove cross section into a desired shape, and for example, a fan-shaped cross section can be formed by isotropic etching, whereas a triangular-shape (nabla shape) cross section can be formed by groove etching as one elective etching.

The side surfaces and/or bottom surfaces of the grooves preferably have the same level of hydrophilicity as at least the substrate surface of the substrate, and more preferably have higher hydrophilicity than the substrate surface.

It is not preferable for the substrate surface to have higher hydrophilicity, because the polymerizable monomer aqueous solution will spread to sections other than grooves. Therefore, the contact angle between the substrate surface and the polymerizable monomer aqueous solution according to the present invention is preferably not smaller than the contact angles between the side surfaces and/or bottom surfaces of the grooves and the polymerizable monomer aqueous solution according to the present invention.

In this regard, it has been confirmed that when the substrate is subjected to UV ozone cleaning for 30 minutes in an example, the hydrophilicity of the substrate surface of the substrate is made excessively strong to cause the aqueous solution to spread to sections other than grooves.

The polymerizable monomer solution according to the present invention preferably includes the polymerizable monomer component, a solvent, a polymerization initiator, and a cross-linking agent.

For the polymerizable monomer aqueous solution according to the present invention, the solvent is preferably mixed with the polymerizable monomer component in a proportion of 5 to 50 mass%, the polymerization initiator in a proportion of 0.01 to 10 mass%, and the cross-linking agent in a proportion of 0.01 to 10 mass%, and more preferably, the solvent is preferably mixed with the polymerizable monomer component in a proportion of 10 to 20 mass%, the polymerization initiator in a proportion of 0.1 to 5 mass%, and the cross-linking agent in a proportion of 0.1 to 1 mass%.

The concentrations of the polymerizable monomer component, polymerization initiator, and cross-linking agent within the ranges mentioned above are preferred in terms of strength of prepared gel and polymerization rate (associated with polymerization retard before filling and polymerization before drying of the filled solution).

The polymerizable monomer aqueous solution within the ranges mentioned above makes it for the contact angle with the substrate easy to decrease within a range of 14° to 55° as described later, through selection of the substrate.

The step (1) according to the present invention is intended to drop the polymerizable monomer aqueous solution containing a polymerizable monomer component onto a portion of a substrate surface that has a pattern composed of fine grooves, the dropping conditions (dropping method, dropping amount, droppingpositions or the like) are not to be considered particularly limited unless the solution is dropped over the entire surface of the substrate.

### (In regard to Step (2))

The step (2) in the method of producing a microstructured gel according to the present invention is a step of moving by capillary action the polymerizable monomer aqueous solution through only the grooves constituting the pattern, when the polymerizable monomer aqueous solution is dropped onto a portion of the substrate with a desired pattern created in the surface thereof. Thus, the polymerizable monomer aqueous solution can move through the grooves constituting the pattern without any power. Therefore, the hydrophilicity/hydrophobicity balance is an important factor between at the substrate surface according to the present invention and in the grooves. More specifically, if the substrate surface is more hydrophilic than the groove bottom surfaces and side surfaces in the grooves, the polymerizable monomer aqueous solution will spread over the substrate surface without moving in the grooves.

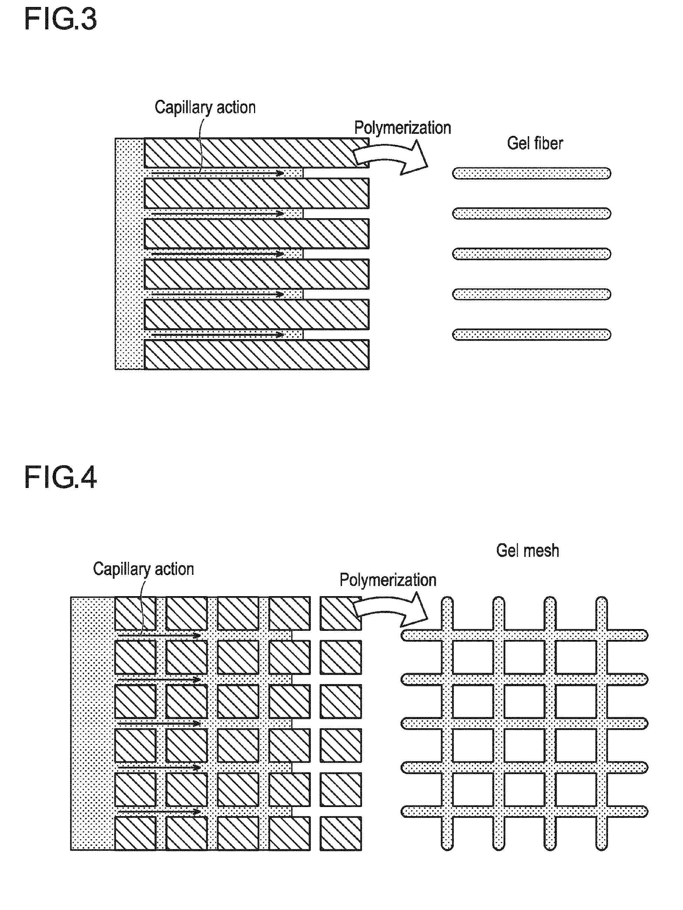

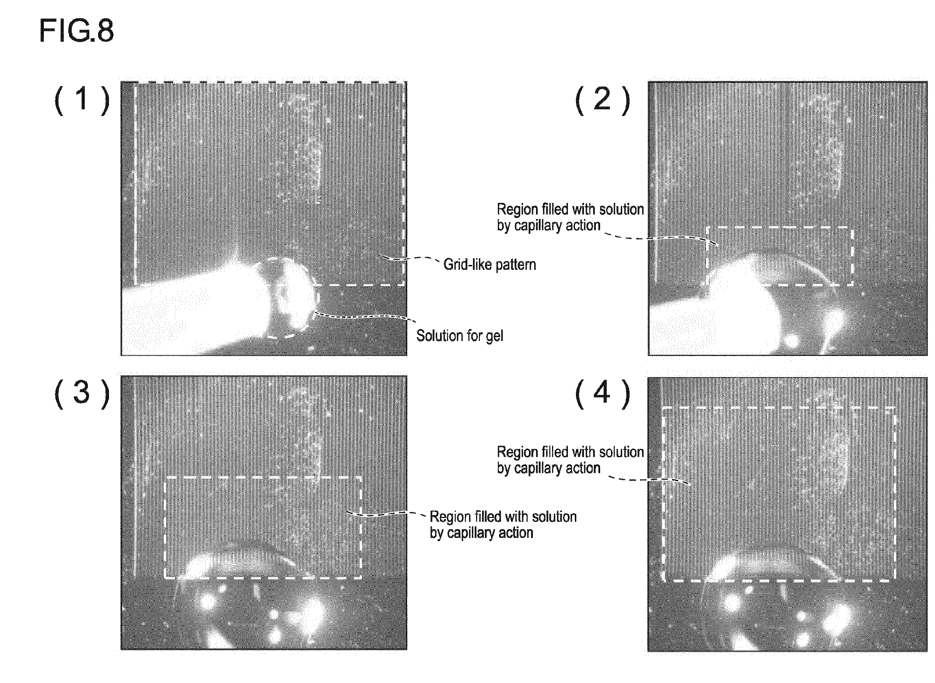

FIGS. 3 and 4 show polymerizable monomer aqueous solutions moved by capillary action along the grooves constituting the patterns in FIGS. 1A and 2A in accordance with step (2). In addition, the movement of a polymerizable monomer aqueous solution according to the present invention by capillary action along grooves constituting a pattern is confirmed in the example described below (see FIG. 8).

Referring to FIGS. 3, 4, and 8, it is understood that droplets of the dropped polymerizable monomer aqueous solution are moved by capillary action through the grooves.

The contact angle between the non-pattern surface of the substrate according to the present invention and the polymerizable monomer aqueous solution according to the present invention can appropriately vary depending on the material of the substrate used and the surface treatment, and is preferably, for example, 14° to 55°, and more preferably 18° to 50°.

As long as the contact angle between the substrate surface and the polymerizable monomer aqueous solution is within the range of 14° to 55°, the polymerizable monomer aqueous solution can move by capillary action continuously in the grooves in the substrate surface, without spreading over the substrate. Alternatively, if the contact angle between the substrate surface and the polymerizable monomer aqueous solution is smaller than 14°, the moving distance by capillary action will be remarkably reduced to fail to achieve the adjustment to a desired length of microstructured gel, whereas if the contact angle is larger than 55°, the aqueous solution will also spread to the substrate surface outside the grooves without moving by capillary action.

It is to be noted that the "non-pattern surface" of the substrate refers to a section of the substrate without the pattern composed of the fine grooves, that is, the substrate surface.

For the measurement of the contact angle according to the present invention, known methods and apparatuses can be used, and in the present invention, a contact angle meter (DM301) from Kyowa Interface Science Co., Ltd. is used to measure the contact angle.

Accordingly, the method of producing a microstructured gel according to the present invention can complete filling by single dropping, because of utilizing capillary action as described in step (2), and differs from the formation of a gel compact by filling grooves of a pattern with a polymerizable monomer aqueous solution with the use of an ink-jet nozzle or the like, and subjecting the polymerizable monomer to polymerization more than once.

### (In regard to Step (3))

Examples of the polymerization process for the polymerizable monomer aqueous solution according to the present invention include, for example, a chemical polymerization method using a radical polymerization initiator, a photopolymerization method using a photopolymerization initiator, or a radiation polymerization method.

The polymerizable monomer component, solvent, polymerization initiator, and cross-linking agent, which are each component of the polymerizable monomer aqueous solution according to the present invention, and the polymerization conditions will be described below.

### "Polymerizable Monomer Component"

The polymerizable monomer component according to the present invention is preferably at least one selected from the group consistingof (meth)acrylamide,N-ethylacrylamide, N-ethyl methacrylamide, N-methyl-N-ethyl acrylamide, N-n-propyl acrylamide, N-n-propyl methacrylamide, N-isopropyl acrylamide, N-methyl-N-n-propyl acrylamide, N-methyl-N-isopropyl acrylamide, N-isopropyl methacrylamide, N, N-dimethyl acrylamide, dimethylaminoethyl acrylate, N, N-diethyl acrylamide, polyethylene glycol diacrylate, N-vinyl-isobutyramide, N-acryloyl pyrrolidine, and N-acryloyl piperidine, and more preferably at least one selected from the group of (meth)acrylamide, isopropylacrylamide, dimethylacrylamide, dimethylaminoethyl acrylate, diethyl acrylamide, and polyethylene glycol diacrylate. These can be used singly, or two or more thereof can be used in combination.

"Polymerization Initiator and Polymerization Condition"
The polymerization initiator according to the present invention is supposed to be appropriately selected depending on the type of the polymerizable monomer component used or the polymerization method.

The chemical polymerization method is carried out by adding a radical polymerization initiator, and if necessary, a polymerization accelerator to a solvent. The polymerization temperature is preferably 10°C to 60°C, and more preferably 15°C to 40°C. In addition, the polymerization time is preferably 30 seconds to 10 minutes, and more preferably 1 minute to 5 minutes. Examples of the radical polymerization initiator can include persulfate such as sodium persulfate, potassium persulfate, or ammonium persulfate; azo compounds such as azobis-2-methylpropionamidine hydrochloride or azoisobutyronitrile; and peroxides such as benzoyl peroxide, lauroyl peroxide, cumene hydroperoxide, or benzoyl peroxide, and these can be used singly, or two or more thereof can be used in combination.

The amount of the polymerization initiator is preferably 0.01 to 10 mass%, more preferably 0.01 to 5 mass%, and further preferably 0.1 to 1 mass% as a concentration in the aqueous solution.

In this case, one or two or more can be used as the polymerization initiator, from reducing agents such as sodium hydrogen sulfite, sodium sulfite, Mohr's salt, sodium bisulfite pyrophosphate, sodium formaldehyde sulfoxylate, or ascorbic acid; and amine compounds such as ethylenediamine, sodium ethylenediaminetetraacetate, glycine, or N,N,N',N'-tetramethylethylenediamine.

In the case of using the polymerization accelerator, the polymerization accelerator is preferably added at 0.01 to 10 mass%, and more preferably added at 0.02 to 1 mass%, as a concentration in the aqueous solution.

The photopolymerization method can be carried out by, for example, adding a photopolymerization initiator in advance to the aqueous solution, and irradiating the polymerizable monomer in grooves constituting a pattern with ultraviolet light.

Examples of the photopolymerization initiator used include, for example, acetophenone, 2,2-diethoxyacetophenone, p-dimethylamino acetophenone, p-dimethylamino propiophenone, benzophenone, p,p'-dichlorobenzophenone, p,p'-bis diethyl amino benzophenone, Michler's ketone, benzyl, benzoin, benzoin methyl ether, benzoinisopropylether, benzoin-n-propylether, benzoin isobutyl ether, benzyl dimethyl ketal, 1-hydroxy-cyclohexyl phenyl ketone, tetramethylthiuram monosulfide, thioxanthone, 2-chloro thioxanthone, 2,4-dimethyl-thioxanthone, 2,2-dimethyl propylene oil diphenyl phosphine oxide, 2-methyl-2-ethylhexanoyl-diphenyl phosphine oxide, 2,6-dimethyl-benzoyl diphenyl phosphine oxide, 2,6-dimethoxy benzoyl diphenyl phosphine oxide, 2,4,6-trimethyl benzoyl diphenyl phosphine oxide, bis(2,6-dimethoxybenzoyl)-2,4,4-trimethylpentyl phosphine oxide, 2,3,6-trimethylbenzoyl-diphenyl phosphine oxide, bis(2,3,6-trimethyl benzoyl )-phenyl phosphine oxide, 2,4,6-trimethoxy benzoyl-diphenyl phosphine oxide, 2,4,6-trichloro benzoyl diphenyl phosphine oxide, 2,4,6-trimethyl benzoyl naphthyl phosphonate, p-dimethylamino benzoic acid, p-diethylaminobenzoic acid, azobisisobutyronitrile, 1,1'-azobis(1-acetoxy-1-phenyl ethane),benzoinperoxide,and di-tert-butylperoxide. These can be used singly, or two or more thereof can be used in combination.

The wavelength of the ultraviolet light is preferably 200 nm to 450 nm, and the irradiance of the ultraviolet light is preferably 100 mJ/cm² to 2000 mJ/cm², and more preferably 500 mJ/cm² to 1500 mJ/cm².

The radiation polymerization method is carried out by irradiating, with radiation, a polymerizable monomer solution filling grooves constituting a pattern formed in a substrate surface. Electron beams are preferred as the radiation, which preferably has an irradiation dose of 10 kGy to 200 kGy, and more preferably 20 kGy to 50 kGy.

In the case of carrying out polymerization with electron beams, it is possible to achieve the polymerization without using any polymerization initiator or polymerization accelerator, and in that case, there is no need for any process for washing the polymerization initiator or accelerator. In addition, the polymerization initiators and polymerization accelerators can be also used, which are given as examples in the chemical polymerization method.

The electron beam irradiation can be carried out with an electron accelerator. The accelerator is classified into a low-energy type, a medium-energy type, or a high-energy type, depending on the magnitude of the voltage for accelerating electrons. The low-energy type electron accelerator is preferred in the polymerization in this step. For example, examples of the low-energy type electron accelerator include low-energy electron beamirradiatorsfrom Hamamatsu Photonics K.K. This is intended to accelerate thermions generated from a filament at a high voltage to increase the energy, and extract the electron beams from a beryllium window foil into atmosphere, and able to radiate electron beams at a relatively low accelerating voltage of 40 kV to 110 kV.

### "Cross-Linking Agent"

The cross-linking agent according to the present invention is appropriately selected depending on the type of the polymerizable monomer component used and the polymerization method, and broadly encompasses cross-linking agents that can introduce a three-dimensional cross-linked structure into the polymerizable monomer by polymerizable double bonds. Specific examples include, for example, divinyl compounds such as N,N'-methylenebis(meth)acrylamide, N,N'-(1,2-dihydroxy-ethylene)-bis(meth)acrylamide, diethylene glycol di(meth)acrylate, (poly)ethylene glycol di(meth) acrylate, triethylene glycol di(meth) acrylate, propylene glycol di(meth)acrylate, trimethylolpropane di(meth) acrylate, trimethylolpropane tri(meth)acrylate, pentaerythritol di(meth)acrylate, pentaerythritol tri(meth)acrylate, pentaerythritol tetra(meth)acrylate, (poly)propylene glycol di(meth)acrylate, glycerol tri(meth)acrylate, glycerol acrylate methacrylate, ethylene oxide-modified trimethylolpropane tri(meth)acrylate, pentaerythritol tetra(meth)acrylate, and dipentaerythritol hexa(meth)acrylate; triallyl cyanurate, triallyl isocyanurate, triallyl phosphate, triallyl amine, poly(meth)allyloxyalkane, (poly) ethylene glycol diglycidyl ether, glycerol diglycidyl ether, ethylene glycol, polyethylene glycol, propylene glycol, glycerin, pentaerythritol, ethylenediamine, polyethylenimine, glycidyl(meth)acrylate, triallyl isocyanurate, trimethylolpropane di(meth)allyl ether, tetrallyloxyethane, and glycerol propoxy triacrylate. These cross-linking agents can be used singly, or two or more thereof can be used in combination.

### "Solvent"

The solvent of the polymerizable monomer aqueous solution according to the present invention is appropriately selected depending on the type of the polymerizable monomer component used and the polymerization method, and can use not only distilled water, ion-exchange water, pure water, ultrapure water, and the like, but also can use aqueous solutions obtained by dissolving a biological substance or solute other than binding compounds. Examples of the solvent include various types of buffer solutions, and specific examples thereof include carbonate buffers, phosphate buffers, acetate buffers, HEPES buffers, and TRIS buffers. Furthermore, the solvent may be mixed with organic solvents such as lower alcohols (methanol, ethanol, and propanol), acetone, and THF.

In the case of using a buffer solution as the solvent of the polymerizable monomer aqueous solution, the pH is preferably 5 to 9.

In addition, salts may be optionally added to the aqueous solution unless the advantageous effect of the present invention is seriously damaged, and specific examples of the salts include NaCl, KCl, sodium phosphates, sodium acetates, calcium chlorides, sodium hydrogen carbonates, and ammonium carbonates. In addition, there is not a limit on the amount of the salt used, and any amount of salt can be used depending on the intended use.

Further, in the case of using a mixed system of water and an organic solvent as the solvent of the aqueous solution according to the present invention, the mass ratio between the water and the organic solvent is preferably 20:1 to 1:1.

### (Example of Preferred Embodiments of Method of Producing Microtructured Gel according to the Present Invention)

An example of preferred embodiments of the method of producing a microstructured gel according to the present invention will be described below.
After a silicon wafer with a predetermined thickness and size is thermally oxidized at 600°C to 1300°C for on the order to 10 seconds to 180 minutes under a gas atmosphere of water vapor or a mixture of water vapor or oxygen with an inert gas, a photoresist film is formed by application to the surface of the silicon oxide film, exposed to light with a photomask with a desired pattern, removed the unreacted resist material, processed into a predetermined size in accordance with a photolithography process, and subjected to an etching process to form grooves in the surface, and if necessary, the photoresist film and the oxide film are removed to obtain a silicon wafer that has a desired pattern.

In addition, the silicon wafer is thermally oxidized, then exposed to hexamethyldisilazane vapor as a pretreatment for applying a photoresist film to change the hydrophilic surface of the silicon oxide film to a hydrophobic surface, and a photoresist film is formed thereon by an application method, then processed into a predetermined size in accordance with a photolithography process, and then subjected to an etching process to form grooves in the surface, thereby providing a silicon wafer that has a desired pattern with hydrophobicity at the substrate surface and hydrophilicity in the grooves.

Besides, after providing a CVD film with TEOS (Tetra Ethyl Ortho Silicate) as a raw material on a silicon wafer with a predetermined thickness and size, a photolithography may be carried out to produce a silicon wafer that has a desired pattern.

In addition, known methods can be used for the method of forming an oxide film on the surface of the silicon wafer, and besides the thermal oxidation method mentioned above, a heat treatment for oxidation at ordinary temperatures, where a silicon wafer with a predetermined thickness and size is left to form a natural oxide film on the surface of the silicon wafer, a plasma anodization treatment, partial-pressure oxidation, oxidation with the addition of a hydrochloric acid, oxidation with the addition of TCA (trichloroethane), an oxidation treatment with the addition of DCE (dichloroethylene) or the like can be thus adopted. Furthermore, a silicon wafer may be purchased which already has a predetermined thickness and has an oxide film or a nitride film on the surface.

The polymerizable monomer component, the polymerization initiator, and the cross-linking agent, and if necessary, the polymerization accelerator are each added in predetermined amounts to a buffer solution (ionic strength from 1 mM to 100 mM) of pH 5 to 9 as a solvent, and mixed to prepare a polymerization monomer solution, and the polymerizable monomer is dropped with a syringe onto the silicon wafer with the desired pattern under an atmosphere at humidity of 5 to 80% RH and at a temperature of 10°C to 30°C. In addition, the dropping site and the dropping amount can be appropriately selected depending on the length and size of the desired microfabricated gel.

However, in each of the step (1) of dropping, with a syringe, the polymerizable monomer onto the silicon wafer with the desired pattern, the step (2) described later, and the step (3) described later, the polymerizable monomer aqueous solution is injected into the fine grooves in an open system, and there is thus a need to keep the polymerizable monomer aqueous solution from drying to evaporate in minute amounts.

It is to be noted that while the order of adding the polymerizable monomer component, the polymerization initiator, and the cross-linking agent, and if necessary, the polymerization accelerator to the solvent is not particularly limited, the polymerization initiator, and the polymerization accelerator added if necessary, are preferably added immediately before the polymerizable monomer aqueous solution is dropped onto the silicon wafer in the case of chemical polymerization (step (1)).

The polymerizable monomer solution dropped onto the silicon wafer is moved by capillary action without any power along the grooves constituting the pattern, without spreading over the surface (substrate surface) of the substrate with the pattern composed of the fine grooves (step (2)).

Then, the polymerizable monomer solution filling the grooves constituting the pattern formed in the silicon wafer surface is left for 1 to 10 minutes under an atmosphere at humidity of 5 to 80% RH and a temperature of 10°C to 30°C, or heated of irradiated with ultraviolet light or electron beams under predetermined conditions, if necessary, to subject the polymerizable monomer solution to polymerization (step (3)).

On completion of polymerization in the step (3) described above, the whole silicon wafer is immersed for cleaning in a large amount of solvent at a temperature of 5°C to 70°C for 10 minutes to 24 hours to extract a microstructured gel, thereby making it possible to produce a microstructured gel according to the present invention. It is to be noted the gel can be also extracted by evaporating and drying the solvent of the polymerizable monomer solution after the completion of polymerization.

The method of producing a microstructured gel according to the present invention may include a step of extracting the polymerized microstructured gel and a step of cleaning with a solvent. Furthermore, the method may include a step of cutting an end of the gel with a cutter or a scalpel.

In the method of producing a microstructured gel according to the present invention, it is easy to extract the microstructured gel because the upper surface of the pattern is opened due to the pattern formed in the surface of the substrate. Examples of the extraction method include a method of immersing the whole silicon wafer in a large amount of solvent at a temperature of 5°C to 70°C for 10 minutes to 24 hours, or drying the whole silicon wafer at a temperature of 10°C to 70°C for 10 minutes to 1 hour.

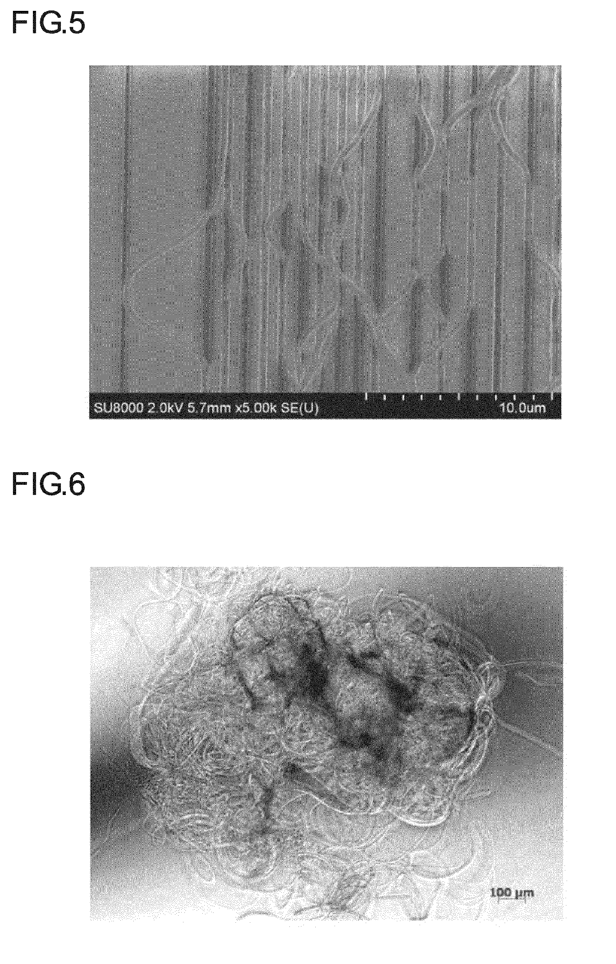

For example, FIG. 5 shows therein a prepared gel fiber with a pattern, which was observed with a scanning electron microscope (from Hitachi High-Technologies Corporation), after the gel fiber was immersed along with a pattern in water until the gel fiber started to peel from the pattern, and dried.

The solvent used in the immersion for extracting the microstructured gel is not particularly limited, for which the solvent used in the polymerizable monomer aqueous solution can be preferably used.

In addition, when droplets of the polymerizable monomer aqueous solution are excessively dropped in dropping the polymerizable monomer aqueous solution onto the substrate with the pattern formed, the polymerizable monomer aqueous solution will also locally spread to a portion of the substrate surface of the substrate other than the grooves, and for example, remain in a massive form only on the section to be subjected to dropping, resulting in gelation. However, as long as a step of removing, such as cutting, only the gelation section in the massive form is appropriately carried out after the completion of the polymerization in the step (3), a desired microstructured gel, for example, a linear gel (gel fiber) or a grid-like gel (gel mesh) can be obtained.

### Examples

### Production Example: Production of Substrate with Pattern Formed

### (1) "Production of Substrate with Pattern of FIG. 1 Formed"

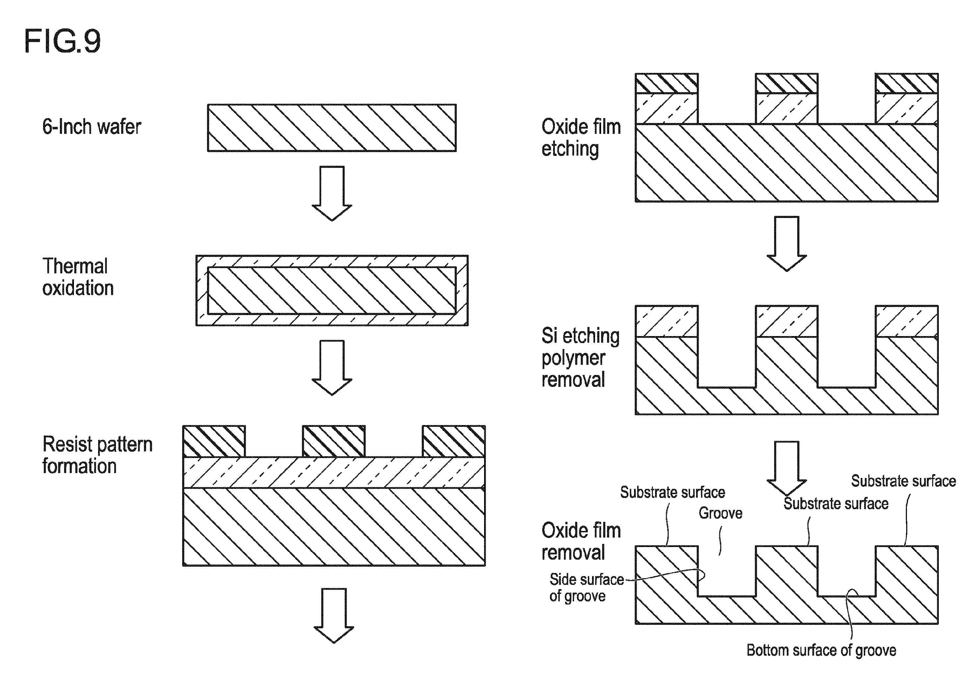

After a silicon wafer of 600 **µ**m in thickness and 6 inches in size was thermally oxidized by use of an RTA furnace with an infrared lamp as a light source at normal pressures for 10 seconds under an atmosphere of 100% oxygen gas at 1000°C to form an oxide film of 30 Å in thickness on the silicon wafer surface, a photoresist film (THMR iN100 (from Tokyo Ohka Kogyo Co., Ltd.)) was formed by a spin coating method onto the surface of the silicon oxide film, and dried on a hot plate at 120°C for 90 seconds. Then, with a photomask with a linear pattern of 1.0 **µ**m in trench width and 3.0 **µ**m in pitch width, the film was exposed to ultraviolet rays for patterning, and subjected to a heat treatment at 110°C for 90 seconds, and the unreacted resist material was removed with an aqueous solution of 2.38 weight% tetramethylammonium hydroxide to form a desired resist pattern. Then, the surface of the substrate was subjected to patterning by carrying out etching under the etching conditions: CHF₃ as an etching gas at 52 SCCM; CF₄ at 20 SCCM; Ar at 96 SCCM; pressure of 200 mTorr; RF power of 700 W; and magnet field of 75 Gaus, to prepare a silicon wafer with the pattern of FIG. 1B composed of linear grooves of 1.0 **µ**m in trench width, 3.0 **µ**m in pitch width, and 6.5 **µ**m in depth in the surface (see FIG. 9). It is to be noted that the pattern was formed into a square of 5 mm on a side as a whole.

### (2) "Production of Substrate with Pattern of FIG. 2 Formed"

After a silicon wafer of 600 **µ**m in thickness and 6 inches in size was thermally oxidized by use of an RTA furnace with an infrared lamp as a light source at normal pressures for 10 seconds under an atmosphere of 100% oxygen gas at 1000°C to form an oxide film of 30 Å in thickness on the silicon wafer surface, a photoresist film (THMR iN100 (from Tokyo Ohka Kogyo Co., Ltd.)) was formed by application onto the surface of the silicon oxide film, and with a photomask with a grid-like pattern of 2. 0 µm in trench width/24 µm in vertical pitch and 40 **µ**m in horizontal pitch, exposed to light under the same conditions as for the formation of the pattern in FIG. 1, the unreacted resist material was removed to process the photoresist film into a predetermined size in accordance with a photolithography process, and an etching process was carried out to prepare a silicon wafer with the pattern of FIG. 2B composed of grid-like grooves of 2.0 **µ**m in trench width/24 **µ**m in vertical pitch, 40 **µ**m in horizontal pitch, and 6.5 **µ**m in depth in the surface (see FIG. 9). It is to be noted that the pattern was formed into a rectangle of 5 mm in length and 4 mm in width as a whole.

### Example 1: Preparation of Microstructured Gel

### (1) "Method of Preparing Polymerizable Monomer Aqueous Solution"

Acrylamide (from Wako Pure Chemical Industries, Ltd.) and N,N'-methylenebisacrylamide (from Wako Pure Chemical Industries, Ltd.) were each added to a phosphate buffered saline (from Invitrogen, Dulbecco's Phosphate Buffer, 14190-144) so that the concentrations of the acrylamide and N,N'-methylenebisacrylamide were respectively 15 mass% and 0.3 mass%, and dissolved and mixed therein. Next, sodium persulfate (from KANTO CHEMICAL CO., INC.) and N,N,N',N'-tetramethylethylenediamine (from Wako Pure Chemical Industries, Ltd.) were each added to the obtained aqueous solution so that the concentrations of the sodium persulfate and N,N,N',N'-tetramethylethylenediamine were respectively 0.26 mass% and 0.2 mass%, thereby providing a polymerizable monomer aqueous solution.

### (2) "Polymerization from Polymerizable Monomer Aqueous Solution"

Then, the polymerizable monomer aqueous solution was dropped with a syringe onto the one end of the silicon wafers with the patterns as shown in FIGS. 1 and 2 under an atmosphere at humidity of 5 to 10% RH and a temperature of 20°C to 26°C (for example, see FIG. 8(1)).

It was confirmed that when the polymerizable monomer aqueous solution was dropped with the syringe, the aqueous solution moved by capillary action through the grooves, and the polymerizable monomer aqueous solution spread into the pattern (see, for example, FIGS. 8(2) to 8(3)). It is to be noted that while the surface of the silicon wafer used herein was not subjected to any treatment for providing hydrophilicity, the wafer was used after a lapse of a sufficient number of days from the preparation, and the oxidation of the surface was progressed to have moderate hydrophilicity.

### (3) "Extraction of Microstructured Gel"

Then, this state was left as it was, the completion of the polymerization was confirmed after 5 minutes from the dropping, and the gels prepared in the pattern grooves were each immersed in large amounts of pure water along with the patterns of FIGS. 1 and 2 for cleaning for 2 hours to prepare a gel fiber and a gel mesh as microstructured gels.

It is to be noted that, although described later, it has been confirmed that the prepared gels spontaneously peel from the patterns (see FIG. 5). In addition, while the polymerization was initiated by the addition of the sodium persulfate (from KANTO CHEMICAL CO., INC.) and the N,N,N',N'-tetramethylethylenediamine (from Wako Pure Chemical Industries, Ltd.) described above, the grooves can be filled by capillary action with the solution by dropping the aqueous solution onto ends of the patterns with the fine grooves prior to the progress of the polymerization. In addition, the filling solution is used for polymerization with the passage of time to turn into a microstructured gel.

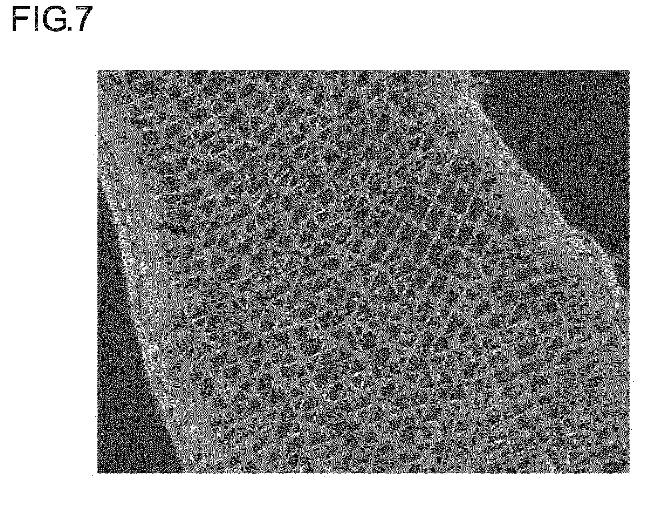

Further, FIG. 8 shows how the polymerizable monomer aqueous solution which was dropped onto a grid-like pattern was gradually filled by capillary action without any power. In addition, FIGS. 6 and 7 show the prepared gel fiber and gel mesh observed under an inverted microscope (from Carl zeiss).
From these results, it can be confirmed that microstructured hydrogels can be prepared by filling the patterns composed of the fine grooves with the solution for the gels by capillary action, and subjecting the solution to polymerization.

### Example 2: Experiment of Introducing Liquid into Patterns using Substrates with Different Contact Angles

### (1) "Preparation of Silicon Wafer with Different Contact Angles"

The surface of the silicon wafer with the pattern of FIG. 1, which was prepared in Example 1, was subjected to UV ozone cleaning by varying the cleaning time from 1 to 30 minutes with the use of a UV-03 cleaner (from Nippon Laser & Electronics Lab, NL-UV253S), thereby preparing seven types of silicon wafers with differently hydrophilic surfaces.

### (2) "Measurement of Contact Angles and Experiment of Introduction into Patterns"

A contact angle meter (DM301) from Kyowa Interface Science Co., Ltd. was used for the measurement of the contact angles. The contact angles were all analyzed by a θ/2 method. First, a liquid was discharged from a syringe with its end downward, which was attached to the contact angle meter, and a droplet of 1 **µ**L was prepared on the end of the syringe. Next, while vertically lowering this syringe, the droplet was brought into contact with a section of the silicon wafer without the pattern (that is, the substrate surface as a non-pattern formation surface) to drop the liquid of 1 **µ**L onto the substrate surface. The droplet spread over the surface in this case was photographed just from the side, and the contact angle was calculated with the use of FAMAS as analysis software supplied with the apparatus. For the experiment of introduction into the pattern, the liquid of 1 **µ**L was dropped onto the boundary between the section without the pattern and the section with the pattern by the same dropping method as described previously to confirm the introduction of the liquid into the pattern and the pattern filled with the liquid. It is to be noted used as the liquid were ultrapure water (JIS K0557 TOC less than 0.02 mg/L), and , a polymerizable monomer solution prepared by adding acrylamide (from Wako Pure Chemical Industries, Ltd.) and N,N'-methylenebisacrylamide (from Wako Pure Chemical Industries, Ltd.) to a phosphate buffered saline (from Invitrogen, Dulbecco's Phosphate Buffer, 14190-144) so that the concentrations of the acrylamide and N,N'-methylenebisacrylamide were respectively 15 mass% and 0.3 mass%.

As a result of the measurement of the contact angles of the ultrapure water and polymerizable monomer solution to the surfaces of the seven types of silicon wafers, as well as the experiment of introduction into the patterns, the introduction of the ultrapure water into the patterns and the patterns filled with the ultrapure water by capillary action were able to be confirmed when the contact angle of the silicon wafer surface to the ultrapure water was 49.8°, 35.0°, or 20.1°. On the other hand, when the contact angle was 78.9° or 60.6°, the introduction of the ultrapure water by capillary action was able to be confirmed, while the introduction distance was short up to the middle of the pattern grooves (introduction distance of 5 mm or less). In addition, when the contact angle was 11.9° or 2.4°, the ultrapure water spread over the silicon wafer surface, and the introduction by capillary action was not able to be confirmed.

In addition, the introduction of the polymerizable monomer aqueous solution into the patterns and the patterns filled with the polymerizable monomer aqueous solution by capillary action were able to be confirmed when the contact angle of the silicon wafer surface to the polymerizable monomer aqueous solution was 41.0°, 30.3°, or 18.4°. On the other hand, when the contact angle was 73.4° or 55.7°, the introduction by capillary action was able to be confirmed, while the introduction distance was short up to the middle of the pattern grooves (introduction distance of 5 mm or less). In addition, when the contact angle was 13.0° or 10.4°, the polymerizable monomer aqueous solution spread over the silicon wafer surface, and the introduction by capillary action was not able to be confirmed.

### Industrial Applicability

The microstructured gel obtained by the production method according to the present invention can be widely used not only in chemistry, biology, and medicine including D· D· S fields such as controlled release, regenerative medicine engineering fields such as a matrix for cell culture, and biomaterial fields such as artificial muscles or artificial nerves, but also in fields related to environmental engineering, such as filters (fibers) and beads in purification systems.

## Claims

1. A method of producing a microstructured gel in a shape in accordance with a pattern, the method comprising the steps of:
dropping a polymerizable monomer aqueous solution containing a polymerizable monomer component onto a portion of a surface of a substrate having a pattern comprising a fine groove in the surface;
moving by capillary action the polymerizable monomer aqueous solution along the groove constituting the pattern; and
subjecting the polymerizable monomer aqueous solution in the groove to polymerization.

2. The method of producing a microstructured gel according to claim 1, wherein a contact angle between a non-pattern formation surface of the substrate and the polymerizable monomer aqueous solution is within a range of 14° to 55°.

3. The method of producing a microstructured gel according to claim 1 or 2, wherein the groove is 100 nm to 1 mm in width, 100 nm to 1 cm in length, and 100 nm to 50 **µ**m in depth.

4. The method of producing a microstructured gel according to any one of claims 1 to 3, wherein the pattern has at least one selected from the group consisting of a line, a grid, a polygon, a wavy line, a spiral, a star, and a honeycomb.

5. The method of producing a microstructured gel according to any one of claims 1 to 4, wherein for the polymerizable monomer aqueous solution, a solvent is mixed with the polymerizable monomer component in a proportion of 5 to 50 mass%, a polymerization initiator in a proportion of 0.01 to 10 mass%, and a cross-linking agent in a proportion of 0.01 to 10 mass%.

6. The method of producing a microstructured gel according to any one of claims 1 to 5, wherein the polymerizable monomer component is at least one selected from the group consisting of (meth)acrylamide, N-ethyl acrylamide, N-ethyl methacrylamide, N-methyl-N-ethyl acrylamide, N-n-propyl acrylamide, N-n-propyl methacrylamide, N-isopropyl acrylamide, N-methyl-N-n-propyl acrylamide, N-methyl-N-isopropyl acrylamide, N-isopropyl methacrylamide, N,N-dimethyl acrylamide, dimethylaminoethyl acrylate, N,N-diethyl acrylamide, polyethylene glycol di-acrylate, N-vinyl-isobutyramide, N-acryloyl pyrrolidine, and N-acryloyl piperidine.
